# EUROPEAN PATENT SPECIFICATION

(11) **EP 4 509 854 B1**
(45) Date of publication and mention of the grant of the patent: **17.06.2026**
(21) Application number: 23884893.1
(22) Date of filing: 31.10.2023
(51) Int. Cl.: G01R 31/387, G01R 31/382, G01R 31/392

(54) **BATTERY LIFE DETERMINATION METHOD AND APPARATUS, ELECTRONIC DEVICE, AND STORAGE MEDIUM**
VERFAHREN UND VORRICHTUNG ZUR BESTIMMUNG DER BATTERIELEBENSDAUER, ELEKTRONISCHE VORRICHTUNG UND SPEICHERMEDIUM
PROCÉDÉ ET APPAREIL DE DÉTERMINATION DE DURÉE DE VIE DE BATTERIE, DISPOSITIF ÉLECTRONIQUE ET SUPPORT DE STOCKAGE

(30) Priority: 31.10.2022 CN 202211346381
(43) Date of publication of application: 19.02.2025
(73) Proprietor: Batterotech Corporation Limited, Fengxian District Shanghai 201417 (CN)
(72) Inventor: LIU, Yang, Shanghai 201417 (CN)
(74) Representative: Studio Torta S.p.A.
(86) International application number: PCT/CN2023/128121
(87) International publication number: WO 2024/093963

(56) References cited:
- CN-A- 109 001 632
- CN-A- 110 888 079
- CN-A- 113 009 351
- CN-A- 114 545 272
- CN-A- 115 097 332
- CN-A- 115 656 858
- JP-A- 2017 228 389
- US-A1- 2020 249 278
- US-A1- 2022 283 234

## Description

### Technical Field

The present application relates to the technical field of battery, for example, to a method and an apparatus for determining life of battery, an electronic device, and a storage medium.

### Background

In order to improve the safety of a lithium-ion battery in use, the cycle life of the lithium-ion battery needs to be determined, avoiding damage caused by the use of the lithium-ion battery beyond its cycle life.

The cycle life of the lithium-ion battery can be determined based on a linear relationship between a capacity retention rate and a battery cycle number.

However, the capacity retention rate and the battery cycle number of the lithium-ion battery may not satisfy the linear relationship due to the possibility of abnormal lithium precipitation or the like during use of the lithium-ion battery. Low accuracy (rate) can be result if the cycle life of the battery directly determined based on the linear relationship. CN 114 545 272 A relates to battery life prediction.

### Summary

The present application provides a method and an apparatus for determining life of battery, an electronic device, and a storage medium, to improve the accuracy of determining the life of battery.

The present application provides a method for determining life of battery, including a first linear determination process and a life determination process,
wherein the first linear determination process including:
performing a charge-discharge cycle on a battery to be tested for a first cycle number;
determining differential capacity curves and capacity fade values of the battery to be tested under different preset cycle numbers;
executing the life determination process when differential capacity peaks of the differential capacity curves and the corresponding preset cycle numbers satisfy a first linear relationship, and the capacity fade values and the corresponding preset cycle numbers satisfy a second linear relationship;
where the life determination process including: determining a cycle number corresponding to a capacity fade threshold of the battery to be tested based on the second linear relationship, determining the cycle number corresponding to the capacity fade threshold of the battery to be tested as a life of the battery to be tested.

Optionally, wherein the method further including: when the differential capacity peaks and the corresponding preset cycle numbers satisfy the first linear relationship, and the capacity fade values and the corresponding preset cycle numbers dissatisfy a second linear relationship, continuing to perform a charge-discharge cycle on the battery to be tested for a second cycle number, to execute a second linear determination process.

Optionally, the determining differential capacity curves and capacity fade values of the battery to be tested under different preset cycle numbers includes:
acquiring discharge data of the battery to be tested under the different preset cycle numbers at intervals of a preset number forwards from a current cycle number obtained when the charge-discharge cycle is completed, where the discharge data includes a capacity and a discharge voltage of the battery to be tested; and
determining the differential capacity curves and the capacity fade values of the battery to be tested under different preset cycle numbers based on the discharge data.

Optionally, the method further including:
determining that the battery to be tested is abnormal when the differential capacity peaks and the corresponding preset cycle numbers dissatisfy the first linear relationship.

Optionally, determining whether the differential capacity peaks and the corresponding preset cycle numbers satisfy the first linear relationship includes:
performing linear fitting on each differential capacity peak and a corresponding preset cycle number based on the first linear relationship to obtain a first function; and
determining that the each differential capacity peak and the corresponding preset cycle number satisfy the first linear relationship when a first fitting variance of the first function is within a first preset range.

Optionally, determining whether the capacity fade values and the corresponding preset cycle numbers satisfy the second linear relationship includes:
performing linear fitting on each capacity fade value and a corresponding preset cycle number based on the second linear relationship to obtain a second function; and
determining that the each capacity fade value and the corresponding preset cycle number satisfy the second linear relationship when a second fitting variance of the second function is within a first preset range.

Optionally, before determining differential capacity curves and capacity fade values of the battery to be tested under different preset cycle numbers, the method further includes:
obtaining at least two initial capacities of the battery to be tested corresponding to initial charge-discharge cycles; and
taking an average value of the at least two initial capacities as a standard capacity of the battery to be tested.

Optionally, the determining capacity fade values of the battery to be tested under different preset cycle numbers includes:
obtaining current capacities of the battery to be tested under the different preset cycle numbers; and
determining the capacity fade value corresponding to the different preset cycle numbers based on a difference between the current capacities of different preset cycle numbers and the standard capacity.

The present application provides an apparatus for determining life of battery, including:
a charge-discharge module, configured to perform a charge-discharge cycle on a battery to be tested;
a differential capacity curve and capacity fade value determination module, configured to determine differential capacity curves and capacity fade values of the battery to be tested under different preset cycle numbers;
a linear determination module, configured to determine whether differential capacity peaks of the differential capacity curves and the corresponding preset cycle numbers satisfy a first linear relationship, and whether the capacity fade values and the corresponding preset cycle numbers satisfy a second linear relationship; and
a life determination module, configured to determine, when the differential capacity peaks and the corresponding preset cycle numbers satisfy the first linear relationship, and the capacity fade values and the corresponding preset cycle numbers satisfy the second linear relationship, a cycle number corresponding to a capacity fade threshold of the battery to be tested based on the second linear relationship, which is a life of the battery to be tested.

The present application provides an electronic device, including:
at least one processor; and
a memory communicatively connected to the at least one processor,
wherein the memory stores a computer program executable by the at least one processor, and the computer program is executed by the at least one processor, to enable the at least one processor to execute the method for determining the life of a battery according to any one of the embodiments of the present application.

The present application provides a computer-readable storage medium, where the computer-readable storage medium stores a computer instruction, and the computer instruction is used to implement the method for determining the life of a battery according to any one of the embodiments of the present application when executed by a processor.

It should be understood that the content described herein is not intended to mark key or important features of the embodiments of the present application, nor to limit its scope.

### Brief Description of the Drawings

The accompanying drawings that need to be used in the description of the embodiments will be briefly described below.
Fig. 1 is a flowchart of a method for determining life of battery provided according to an embodiment of the present application;
Fig. 2 is a flowchart of another method for determining life of battery provided according to an embodiment of the present application;
Fig. 3 is a first change curve of differential capacity peaks with respect to cycle numbers;
Fig. 4 is a first change curve of logarithms of capacity fade values with respect to logarithms of cycle numbers;
Fig. 5 is a second change curve of differential capacity peaks with respect to cycle numbers;
Fig. 6 is a second change curve of logarithms of capacity fade values with respect to logarithms of cycle numbers;
Fig. 7 is a flowchart of another method for determining life of battery provided according to an embodiment of the present application;
Fig. 8 is a schematic structural diagram of an apparatus for determining life of battery provided according to an embodiment of the present application;
Fig. 9 is a schematic structural diagram of an electronic device implementing a method for determining life of battery according to an embodiment of the present application.

### Detailed Description of the Embodiments

The methods in the embodiments of the present application will be described below with reference to the accompanying drawings in the embodiments of the present application.

The terms "first", "second", etc. in the description and claims of the present application and the above accompanying drawings are used to distinguish similar objects and are not necessarily used to describe a particular order or sequence. It should be understood that the data used in this way may be interchanged under appropriate circumstances, such that the embodiment of the present application described herein may be implemented in sequences other than those illustrated or described herein. In addition, the terms "include/comprise", "have/has", and any variation thereof are intended to cover non-exclusive inclusions, for example, processes, methods, systems, products or devices including a series of steps or units shown in the embodiments of the present application, other processes, methods, systems or devices including a series of steps or units not clearly listed, or other steps or units inherent to these processes, methods, products or devices.

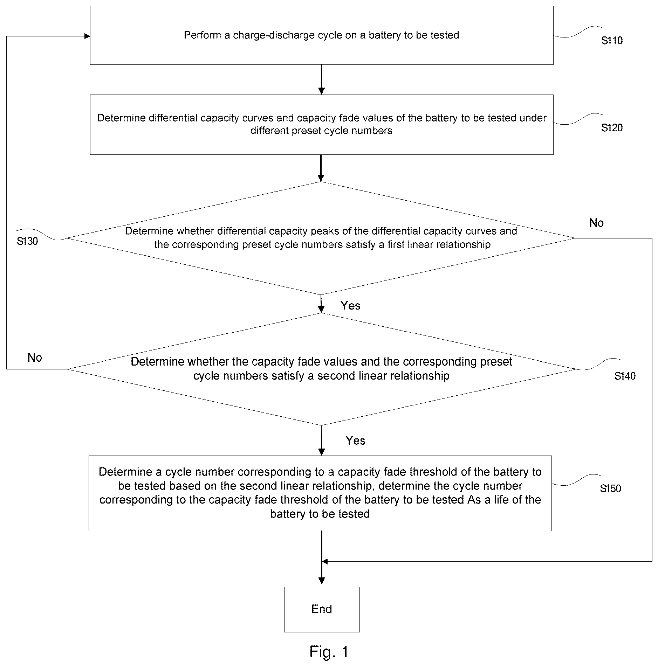

Fig. 1 is a flowchart of a method for determining life of battery provided according to an embodiment of the present application. As shown in Fig. 1, the method for determining life of battery includes the following steps.

At step of S110, performing a charge-discharge cycle on a battery to be tested.

For example, the battery to be tested is a lithium-ion battery whose life needs to be determined. For example, the life of the battery to be tested is a cycle life of the battery to be tested, that is, the number of charge-discharge cycles that the battery to be tested can undergo. One charge-discharge cycle includes a complete charge and a discharge process. During the charge-discharge cycle on the battery to be tested, the cycle number and discharge data of the battery to be tested can be recorded in real time, which provides a basis for the subsequent determination the life of the battery to be tested.

At step of S120, determining differential capacity curves and capacity fade values of the battery to be tested under different preset cycle numbers.

For example, a differential capacity curve is a change curve of differential capacities of the battery to be tested with respect to discharge voltages of the battery to be tested. The differential capacity of the battery to be tested is a differential of the battery to be tested to the discharge voltage. When a preset cycle number reached, the differential capacity of the battery to be tested can be determined based on the capacity and the discharge voltage of the battery to be tested during discharge, so the differential capacity curve can be determined. For example, a capacity fade value is a reduce value of the capacity of the battery to be tested relative to a standard capacity. When the preset cycle number reached, the capacity fade value of the battery to be tested is determined based on the capacity of the battery to be tested during the discharge and the standard capacity of the battery to be tested.

At step of S130, determining whether differential capacity peaks of the differential capacity curves and corresponding preset cycle numbers satisfy a first linear relationship, when the differential capacity peaks and corresponding preset cycle numbers satisfy the first linear relationship, step S140 is executed; or when the differential capacity peaks and corresponding preset cycle numbers dissatisfy the first linear relationship, the process ends.

The differential capacity curve includes at least one characteristic peak, where the characteristic peak represents that a material of the battery to be tested undergoes a phase change. For example, a differential capacity peak of the differential capacity curve is a peak value corresponding to a first characteristic peak, where the first characteristic peak is a characteristic peak corresponding to a minimum discharge voltage in the at least one characteristic peak. For example, the first linear relationship is y₁ = a₁x + b₁, where y₁ is the peak differential capacity, x is the first cycle number or the second cycle number, a₁ is a first proportionality coefficient, and b₁ is a first constant coefficient. When the differential capacity peaks and the corresponding preset cycle numbers satisfy the first linear relationship, it indicates that a capacity change of the battery to be tested is normal, a state of the battery to be tested is normal, and the battery to be tested can be continuously determined. When the differential capacity peaks and the corresponding preset cycle numbers dissatisfy the first linear relationship, it indicates that the capacity change of the battery to be tested is abnormal, and the determination of the charge-discharge and life of the battery to be tested is ended.

In this embodiment, the determination whether the differential capacity peaks of the differential capacity curves and the corresponding preset cycle numbers satisfy the first linear relationship may be a determination whether the differential capacity peak under a current preset cycle number and the preset cycle number satisfy the first linear relationship formed by data points in previous charge-discharge cycle.

At step of S140, determining whether the capacity fade values and corresponding preset cycle numbers satisfy a second linear relationship, when the capacity fade values and corresponding preset cycle numbers satisfy the second linear relationship, step S150 is executed; or when the capacity fade values and corresponding preset cycle numbers dissatisfy the second linear relationship, the process returns to continue to execute the step S110.

In this embodiment, the determination whether the capacity fade values and the corresponding preset cycle numbers satisfy the second linear relationship may be a determination whether the capacity fade value under the current preset cycle number and the preset cycle number satisfy the second linear relationship formed by the data points in the previous charge-discharge cycle.

When it is determined that the capacity fade values and the corresponding preset cycle numbers dissatisfy the second linear relationship, it indicates that a current linear derivation law has changed, the data needs to be further actually measured, and a new linear rule starting from an abnormal point is updated.

For example, the second linear relationship is lny₂ = a₂lnx + b₂, where y₂ is the capacity fade value, x is the first cycle number or the second cycle number, a₂ is a second proportionality coefficient, and b₂ is a second constant coefficient. When it is determined that the capacity fade values and the corresponding preset cycle numbers satisfy the second linear relationship, it indicates that capacity fade of the battery to be tested is within a normal range. When the capacity fade values of the battery to be tested and the corresponding preset cycle numbers satisfy the second linear relationship, the life of the battery to be tested can be determined based on the second linear relationship and a capacity fade threshold of the battery to be tested. When the capacity fade values and the corresponding preset cycle numbers dissatisfy the second linear relationship, it indicates that the battery to be tested may have abnormal lithium precipitation during first round of charge-discharge cycle, the charge-discharge cycle needs to be continuously performed on the battery to be tested, and the differential capacity curves and the capacity fade values of the battery to be tested under the different preset cycle numbers in second round of charge-discharge cycle are determined. When the capacity fade values and the corresponding preset cycle numbers still dissatisfy the second linear relationship after the second round of charge-discharge cycle, the charge-discharge cycle is continuously performed on the battery to be tested. After the second round of charge-discharge cycle, when the differential capacity peaks of the differential capacity curves and the corresponding preset cycle numbers satisfy the first linear relationship, and the capacity fade values and the corresponding preset cycle numbers satisfy the second linear relationship, fitting is performed on the corresponding capacity fade values of the battery to be tested under the different preset cycle numbers, and the preset cycle numbers in the second round of charge-discharge cycle based on the second linear relationship, to determine the life of the battery to be tested based on a function for the capacity fade value and the preset cycle number.

Exemplarily, for example, the first charge-discharge round is performed for 200 cycle numbers. When the capacity fade values and the preset cycle numbers dissatisfy the second linear relationship, it indicates that the battery to be tested may have abnormal lithium precipitation during the first round of charge-discharge cycle, and the charge-discharge cycle is continuously performed. For example, when the second charge-discharge round is performed for 1,000 cycle numbers, for example the preset cycle numbers in the second round of charge-discharge cycle are 1,000, 800, 600 and 400. When, during the charge-discharge cycle on the battery to be tested for 1,000th, 800th, 600th and 400th, the differential capacity peaks of the differential capacity curves and the preset cycle numbers satisfy the first linear relationship, and the capacity fade values and the preset cycle numbers satisfy the second linear relationship, fitting is performed on the capacity fade values and the preset cycle numbers during the cycle on the battery to be tested for 1,000th, 800th, 600th and 400th based on the second linear relationship, to determine the life of the battery to be tested based on the function for the capacity fade value and the preset cycle number.

Through linear judgment the parameters of the battery to be tested, the function of the capacity fade value and the preset cycle number can be accurately determined after the battery to be tested has abnormal lithium precipitation. Compared with the determination of the life of the battery to be tested by directly substituting the parameters of the battery to be tested into the linear relationship, the life of the battery to be tested can be determined more accurately.

At step of S150, determining a cycle number corresponding to a capacity fade threshold of the battery to be tested based on the second linear relationship, determining the cycle number corresponding to the capacity fade threshold of the battery to be tested as a life of the battery to be tested.

For example, the capacity fade threshold is a corresponding capacity fade value when the capacity is faded to 80% of the standard capacity, or a corresponding capacity fade value when the capacity is faded to 70% of the standard capacity. Different application scenarios have different requirements for the battery, and capacity fade threshold may also be different. Fitting is performed on the capacity fade values corresponding to the different preset cycle numbers and the preset cycle number based on the second linear relationship, the function of the capacity fade value and the preset cycle number is determined, and the capacity fade threshold is substituted into the function for the capacity fade value and the preset cycle number to obtain the cycle number, namely the life of the battery to be tested.

The linear determination process includes the step S110 to the step S140. The life determination process includes the step S150. When it is determined in the linear determination process that the differential capacity peaks of the differential capacity curves and the corresponding preset cycle numbers satisfy the first linear relationship, and the capacity fade values and the corresponding preset cycle numbers dissatisfy the second linear relationship, the step S110 to the step S140 continues to be executed. And when the differential capacity peaks of the differential capacity curves and the corresponding preset cycle numbers satisfy the first linear relationship, and the capacity fade values and the corresponding preset cycle numbers satisfy the second linear relationship, the linear determination process ends. The life determination process is executed to determine the life of the battery to be tested.

In the method of this embodiment, the first linear determination process is set, such that when it is determined in the linear determination process that the differential capacity peaks of the differential capacity curves and the corresponding preset cycle numbers satisfy the first linear relationship, and the capacity fade values and the corresponding preset cycle numbers dissatisfy the second linear relationship, it indicates that the battery to be tested may have abnormal lithium precipitation during the first round of charge-discharge cycle, the charge-discharge cycle needs to be continuously performed on the battery to be tested, and the next linear determination process is executed. In a second round of charge-discharge cycle, the differential capacity curves and the capacity fade values under the different preset cycle numbers are determined, and the linear determination is continuously performed. When the capacity fade values and the corresponding preset cycle numbers still dissatisfy the second linear relationship after the second round of charge-discharge cycle, the linear determination process is continuously executed, and the charge-discharge cycle is continuously performed on the battery to be tested. When, after the second round of charge-discharge cycle, the differential capacity peaks of the differential capacity curves and the corresponding preset cycle numbers satisfy the first linear relationship, and the capacity fade values and the corresponding preset cycle numbers satisfy the second linear relationship, fitting is performed on the capacity fade values corresponding to the different preset cycle numbers and the preset cycle numbers in the second round of charge-discharge cycle based on the second linear relationship, the function of the capacity fade value and the preset cycle number is determined, and the capacity fade threshold is substituted into the function of the capacity fade value and the preset cycle number to obtain the cycle number, namely the life of the battery to be tested. Through linear judgment the parameters of the battery to be tested, the function of the capacity fade value and the preset cycle number can be accurately determined after the battery to be tested has an abnormal situation (such as abnormal lithium precipitation). Compared with the determination of the life of the battery to be tested by directly substituting the parameters of the battery to be tested into the linear relationship, the life of the battery to be tested can be determined more accurately, and the accuracy of determining the life of the battery is improved.

Additionally, in the method of this embodiment, a low current calibration test other than the charge-discharge cycle does not need to be set, which shortens a duration for determining the life of the battery.

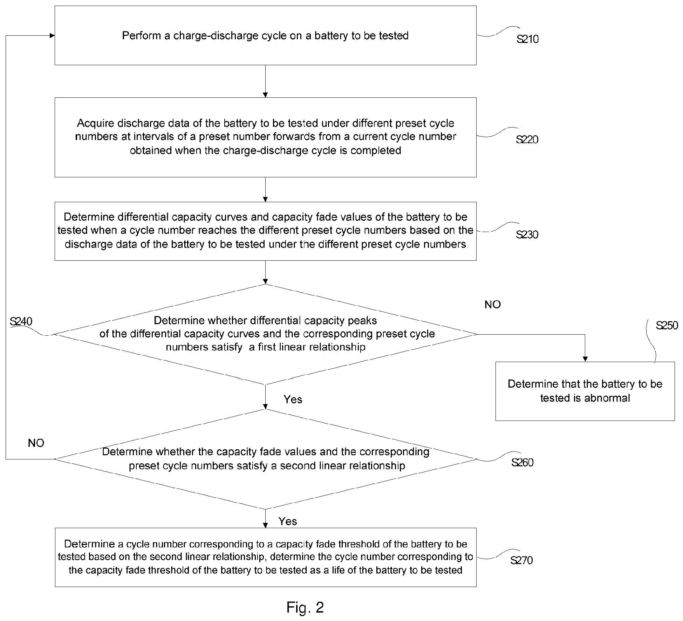

Fig. 2 is a flowchart of another method for determining life of battery provided according to an embodiment of the present application. Optionally, referring to Fig. 2, the method for determining life of battery includes the following steps.

At step of S210, performing the charge-discharge cycle on the battery to be tested.

At step of S220, acquiring discharge data of the battery to be tested under different preset cycle numbers at intervals of a preset number forwards from a current cycle number when the charge-discharge cycle is completed, where the discharge data includes a capacity and a discharge voltage of the battery to be tested.

After the charge-discharge cycle is ended, a plurality of preset cycle numbers are obtained at intervals of a preset number forwards from the current cycle number obtained when the charge-discharge cycle is completed. Exemplarily, the number of charge-discharge cycles of the battery to be tested is, for example, N, where N is a positive integer greater than 0. A plurality of preset cycle numbers are selected forwards from the cycle number obtained when the charge-discharge cycle is completed, and for example the plurality of preset cycle numbers are N, N-m, N-2m...N-km, where k ≥ 2, m ≥ 10, and N-km > 0. Exemplarily, when N is 200, m = 50, k = 2, and the preset cycle numbers are 200, 150 and 100, the capacities and discharge voltages of the battery to be tested during discharge under the condition of cycle for 200 times, 150 times and 100 times are obtained. When the capacity fade values and the corresponding preset cycle numbers dissatisfy the second linear relationship, it indicates that the battery to be tested may have abnormal lithium precipitation during the first round of charge-discharge cycle, and the charge-discharge cycle is continuously performed. When the second round of charge-discharge cycle is performed for, for example, 1,000th, the preset cycle numbers in the second round of charge-discharge cycle are, for example, 1,000, 800, 600 and 400. After each cycle is ended, a plurality of preset cycle numbers in each cycle are obtained at intervals of a preset number forwards from a current cycle number obtained when each charge-discharge cycle is completed.

At step of S230, determining differential capacity curves and capacity fade values of the battery to be tested when a cycle number reaches the different preset cycle numbers based on the discharge data of the battery to be tested under the different preset cycle numbers.

A differential capacity of the battery to be tested can be determined based on the capacity and the discharge voltage of the battery to be tested during the discharge, to determine the differential capacity curves under the different preset cycle numbers. When the cycle number of the battery to be tested reaches the preset cycle numbers, the capacity fade values of the battery to be tested under the different preset cycle numbers are determined based on the capacity of the battery to be tested during the discharge and the standard capacity of the battery to be tested.

Exemplarily, when the cycle number is 200, the differential capacity curves and the capacity fade values of the battery to be tested when the cycle numbers reach 200, 150 and 100 are determined by obtaining the capacities and the discharge voltages of the battery to be tested during the discharge under the condition of cycle for 200 times, 150 times and 100 times.

At step of S240, determining whether differential capacity peaks of the differential capacity curves and the corresponding preset cycle numbers satisfy a first linear relationship: when dissatisfy the first linear relationship, step S250 is executed; or when satisfy the first linear relationship, step S260 is executed.

At step of S250, determining that the battery to be tested is abnormal.

When the differential capacity peaks and the corresponding preset cycle numbers dissatisfy the first linear relationship, the differential capacity may undergo a sudden change during once discharge, that is, the differential capacity of the battery to be tested may undergo a sudden change, the capacity of the battery to be tested may undergo a significant change, and the material of the battery to be tested may undergo a significant phase change, such that it is determined that the battery to be tested is abnormal, and the battery to be tested is not subjected to the charge-discharge cycle and the life determination any more.

At step of S260, determining whether the capacity fade values and the corresponding preset cycle numbers satisfy a second linear relationship, when the capacity fade values and the corresponding preset cycle numbers satisfy the second linear relationship, step S270 is executed; or when the capacity fade values and the corresponding preset cycle numbers dissatisfy the second linear relationship, the process returns to continue to execute the step S210.

At step of S270, determining a cycle number corresponding to a capacity fade threshold of the battery to be tested based on the second linear relationship, determining the cycle number corresponding to the capacity fade threshold of the battery to be tested as a life of the battery to be tested.

Optionally, the determining whether the differential capacity peaks and the corresponding preset cycle numbers satisfy a first linear relationship includes:
At step of c1, performing linear fitting on each peak differential capacity and a corresponding preset cycle number to obtain a first function based on the first linear relationship.

The first function is a function for the peak differential capacity with respect to the cycle number. The linear fitting is performed on the peak differential capacity and the corresponding preset cycle number to obtain the first function based on the first linear relationship y₁ = a₁x + b₁, wherein the first function is used to determine whether the peak differential capacity and the corresponding preset cycle number satisfy the first linear relationship.

At step of c2, when a first fitting variance of the first function is within a first preset range, the peak differential capacity of the battery to be tested and the corresponding preset cycle number satisfy the first linear relationship.

When the first fitting variance of the first function is within the first preset range, for example, the first fitting variance R₁² is greater than 0.95, it indicates that over-fitting and under-fitting do not occur, thereby determining that the peak differential capacity of the battery to be tested and the corresponding preset cycle number satisfy the first linear relationship.

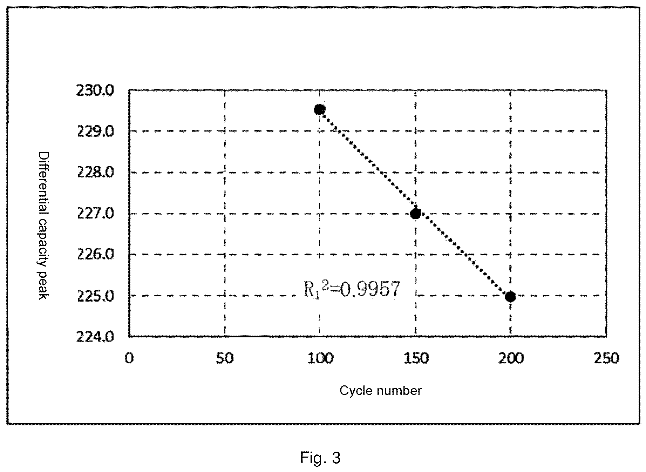

Exemplarily, Table 1 is a first schematic table of differential capacity peaks corresponding to preset cycle numbers and discharge voltages. Fig. 3 is a first change curve of differential capacity peaks with respect to cycle numbers. Fitting is performed on the differential capacity peaks and the corresponding preset cycle numbers in Table 1 based on the first linear relationship to obtain the first change curve of the differential capacity peaks with respect to the cycle numbers as shown in Fig. 3.

**Table 1 First schematic table of differential capacity peaks and discharge voltages corresponding to preset cycle numbers**

| Preset cycle number | Discharge voltage (V) | Peak differential capacity |
|---|---|---|
| 100 | 3.496 | 229.5 |
| 150 | 3.496 | 227.0 |
| 200 | 3.497 | 225.0 |

As shown in Fig. 3, almost all data points fall on the curve, and the first fitting variance R₁² = 0.9957 which is greater than 0.95, thus determining that the differential capacity peaks and the corresponding preset cycle numbers satisfy the first linear relationship.

Optionally, the determining whether the capacity fade values and the corresponding preset cycle numbers satisfy a second linear relationship includes the following steps.

At step of step d1, performing linear fitting on each capacity fade value and a corresponding preset cycle number to obtain a second function based on the second linear relationship.

The second function is a function for a logarithm of the capacity fade value with respect to a logarithm of the cycle number. The linear fitting is performed on the logarithm of the capacity fade value with respect to the logarithm of the corresponding preset cycle number to obtain the second function based on the second linear relationship lny₂ = a₂lnx + b₂, to determine whether the capacity fade threshold and the corresponding preset cycle number satisfy the second linear relationship.

At step of step d2, when a second fitting variance of the second function is within a first preset range, the capacity fade value and the corresponding preset cycle number satisfy the second linear relationship.

When the second fitting variance of the second function is within the first preset range, for example, the second fitting variance R₂² is greater than 0.95, it indicates that over-fitting and under-fitting do not occur, thereby determining that the capacity fade value of the battery to be tested and the corresponding preset cycle number satisfy the second linear relationship.

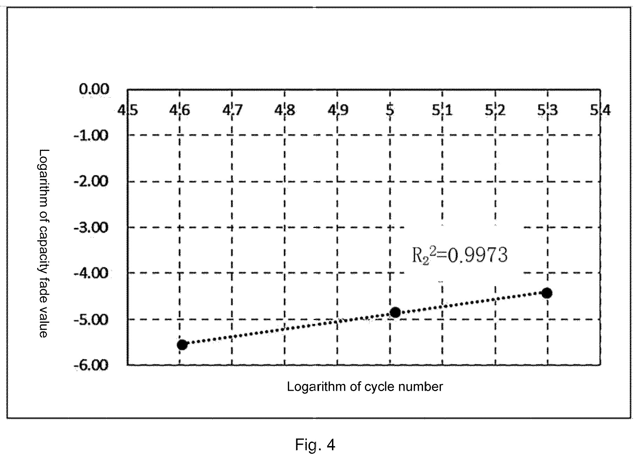

Exemplarily, Fig. 4 is a first change curve of logarithms of capacity fade values with respect to logarithms of cycle numbers. Fitting is performed on the capacity fade values and the corresponding preset cycle numbers based on the second linear relationship to obtain the first change curve of the logarithms of the capacity fade values with respect to the logarithms of the cycle numbers as shown in Fig. 4. As shown in Fig. 4, almost all points fall on the curve, and the second fitting variance R₂² = 0.9973 which is greater than 0.95, thus determining that the capacity fade values and the corresponding preset cycle numbers satisfy the second linear relationship.

In addition, capacity retention rates of the battery to be tested under the cycle numbers of 500, 1,000 and 1,200 are calculated based on the first change curve of the differential capacity peaks with respect to the cycle numbers in Fig. 3 and the first change curve of the logarithms of the capacity fade values with respect to the logarithms of the cycle numbers in Fig. 4, and are compared with actually measured data. Table 2 is a first schematic table of calculated capacity retention rates corresponding to cycle numbers and actually measured capacity retention rates. As shown in Table 2, deviations between the calculated capacity retention rates and the actually measured capacity retention rates are small, and the calculated capacity retention rates are very close to the actually measured capacity retention rates. This indicates that the accuracy of the first change curve of the differential capacity peaks with respect to the cycle numbers shown in Fig. 3 and the first change curve of the logarithms of the capacity fade values with respect to the logarithms of the cycle numbers shown in Fig. 4 is high.

**Table 2 First schematic table of calculated capacity retention rates corresponding to cycle numbers and actually measured capacity retention rates**

| Cycle number | Calculated capacity retention rate | Actually measured capacity retention rate | Deviation |
|---|---|---|---|
| 500 | 96.6% | 96.5% | 0.10% |
| 1000 | 91.9% | 92.4% | -0.54% |
| 1200 | 89.7% | 89.5% | 0.22% |

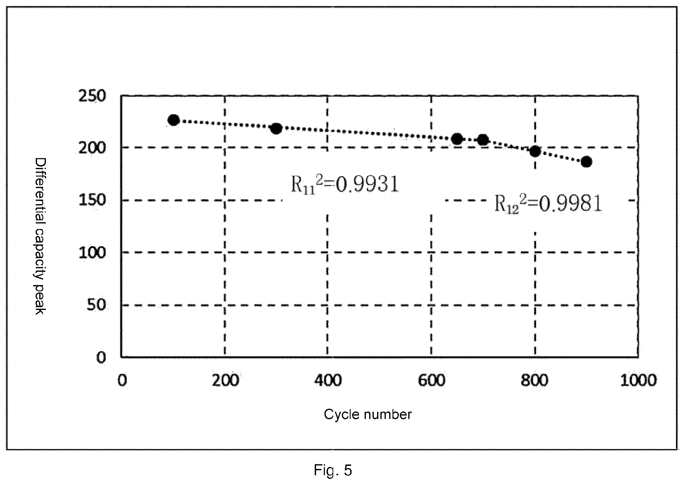

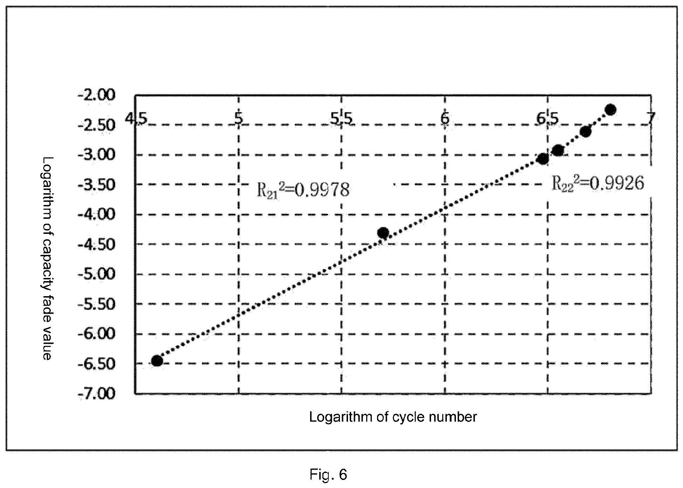

In another embodiment, when the battery to be tested has an abnormal situation, such as abnormal lithium precipitation, the capacity fade value of the battery to be tested and the corresponding preset cycle numbers may not satisfy the second linear relationship. When the battery to be tested is charged or discharged, a larger pretightening force is introduced when the cycle is performed for the 700th time to cause abnormal lithium precipitation, and a peak differential capacity corresponding to the preset cycle number and a discharge voltage are obtained. Table 3 is a second schematic table of differential capacity peaks corresponding to preset cycle numbers and discharge voltages. Fig. 5 is a second change curve of differential capacity peaks with respect to cycle numbers. Fig. 6 is a second change curve of logarithms of capacity fade values with respect to logarithms of cycle numbers. Fitting is performed on the differential capacity peaks and the corresponding preset cycle numbers in Table 3 based on the first linear relationship to obtain the second change curve of the differential capacity peaks with respect to the cycle numbers as shown in Fig. 5, and the second change curve of the logarithms of the capacity fade values with respect to the logarithms of the cycle numbers as shown in Fig. 6 is obtained based on the capacity fade values corresponding to the preset cycle numbers in Table 3.

**Table 3 Second schematic table of differential capacity peaks and discharge voltages corresponding to preset cycle numbers**

| Preset cycle number | Discharge voltage (V) | Capacity fade value | Peak differential capacity |
|---|---|---|---|
| 100 | 3.493 | 0.16% | 226.6 |
| 300 | 3.495 | 1.34% | 218.8 |
| 650 | 3.494 | 4.62% | 208.8 |
| 700 | 3.496 | 5.38% | 207.9 |
| 800 | 3.499 | 7.32% | 196.5 |
| 900 | 3.490 | 10.54% | 186.7 |

As shown in Fig. 5, in the first round of charge-discharge cycle (first 700 cycle numbers), almost all data points fall on a first curve segment, and the first fitting variance R₁₁² = 0.9931 which is greater than 0.95, thus determining that in the first round of charge-discharge cycle, the differential capacity peaks and the corresponding preset cycle numbers satisfy the first linear relationship. In the second round of charge-discharge cycle (700th to 900th of cycle), almost all data points fall on a second curve segment, and the first fitting variance R₁₂² = 0.9981 which is greater than 0.95, thus determining that in the second round of charge-discharge cycle, the differential capacity peaks and the corresponding preset cycle numbers satisfy the first linear relationship. As shown in Fig. 6, in the first round of charge-discharge cycle (first 700 cycle numbers), almost all points fall on a first curve segment, and the second fitting variance R₂² = 0.9978 which is greater than 0.95, thus determining that in the first round of charge-discharge cycle, the capacity fade values and the corresponding preset cycle numbers satisfy the second linear relationship. In the second round of charge-discharge cycle (700th to 900th of cycle), almost all points fall on a second curve segment, and the second fitting variance R₂² = 0.9926 which is greater than 0.95, thus determining that in the second round of charge-discharge cycle, the capacity fade values and the corresponding preset cycle numbers satisfy the second linear relationship. Therefore, the life of the battery to be tested can be determined based on the function for the capacity fade value and the cycle number determined in the second round of charge-discharge cycle.

In addition, piecewise capacity retention rates under the cycle numbers of 1,000, 1,100 and 1,200 are calculated based on the second change curve of the differential capacity peaks with respect to the cycle numbers in Fig. 5 and second segment of the second change curve of the logarithms of the capacity fade values with respect to the logarithms of the cycle numbers in Fig. 6; fitting is performed on the differential capacity peaks and the preset cycle numbers in Table 3 to obtain a one-segment curve, and fitting is performed on the capacity fade values corresponding to the preset cycle numbers and the preset cycle numbers in Table 3 to obtain a one-segment curve; and single calculated capacity retention rates are obtained based on the one-segment curves and compared with actually measured data. Table 4 is a second schematic table of calculated capacity retention rates corresponding to cycle numbers and actually measured capacity retention rates.

**Table 4 Second schematic table of calculated capacity retention rates corresponding to cycle numbers and actually measured capacity retention rates**

| Cycle number | Single calculated capacity retention rate | Piecewise calculated capacity retention rate | Actually measured capacity retention rate | Single deviation | Piecewise deviation |
|---|---|---|---|---|---|
| 1000 | 89.5% | 86.3% | 86.4% | 3.7% | -0.07% |
| 1100 | 87.6% | 82.3% | 82.4% | 6.2% | -0.14% |
| 1200 | 85.5% | 77.7% | 77.9% | 9.8% | -0.22% |

As shown in Table 4, piecewise deviations between the piecewise calculated capacity retention rates and the actually measured capacity retention rates are small, and single deviations between the single calculated capacity retention rates and the actually measured capacity retention rates are large. This indicates that the accuracy of the second change curve of the differential capacity peaks with respect to the cycle numbers shown in Fig. 5 and the second change curve of the logarithms of the capacity fade values with respect to the logarithms of the cycle numbers shown in Fig. 6 is high, that is, the life of the battery to be tested that is calculated based on a piecewise curve is more accurate.

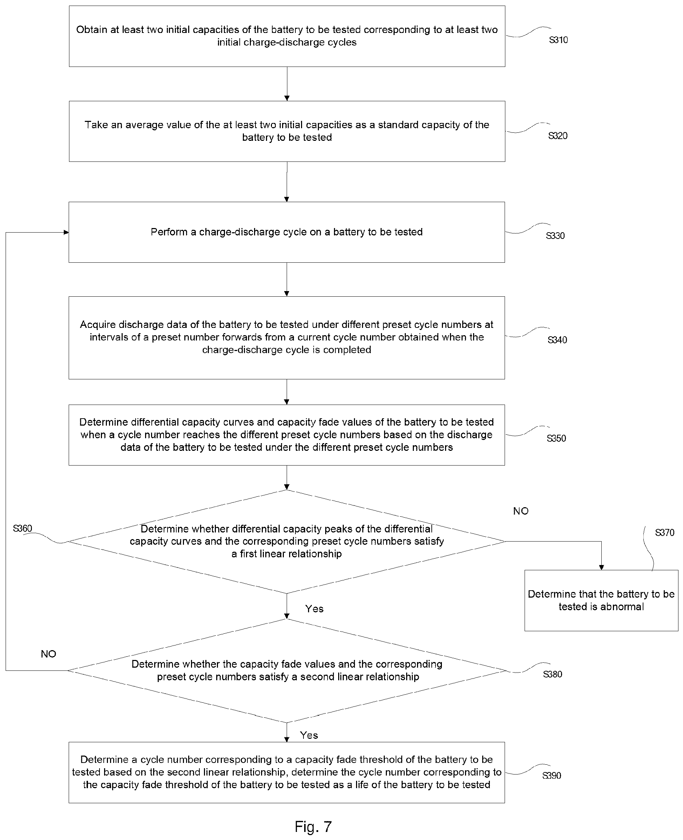

Fig. 7 is a flowchart of another method for determining life of battery provided according to an embodiment of the present application. Optionally, referring to Fig. 7, the method for determining life of battery includes the following steps.

At step of S310, obtaining at least two initial capacities of the battery to be tested corresponding to initial charge-discharge cycles.

The at least two initial cycles refer to at least two cycles in a process that the battery to be tested starts to be charged or discharged. For example, the initial capacities of the battery to be tested during three initial cycles are obtained, that is, an initial capacity of the battery to be tested during first discharge, an initial capacity of the battery to be tested during second discharge, and an initial capacity of the battery to be tested during third discharge are obtained. When the battery to be tested starts to be charged or discharged, the material performance of the battery to be tested is good, and the capacity fade of the battery to be tested can be ignored. So it is convenient to accurately determine the standard capacity of the battery to be tested by obtaining the initial capacities of the battery to be tested during the at least two initial cycles.

At step of S320, taking an average value of the at least two initial capacities as a standard capacity of the battery to be tested.

Exemplarily, when the initial capacities of the battery to be tested during the three initial cycles are obtained, the average value of the initial capacity of the battery to be tested during the first discharge, the initial capacity of the battery to be tested during the second discharge, and the initial capacity of the battery to be tested during the third discharge is used as the standard capacity of the battery to be tested.

At step of S330, performing a charge-discharge cycle on the battery to be tested.

At step of S340, acquiring discharge data of the battery to be tested under different preset cycle numbers at intervals of a preset number forwards from a current cycle number obtained when the charge-discharge cycle is completed, where the discharge data includes a capacity and a discharge voltage of the battery to be tested.

At step of S350, determining differential capacity curves and capacity fade values of the battery to be tested when a cycle number reaches the different preset cycle numbers based on the discharge data of the battery to be tested under the different preset cycle numbers.

At step of S360, determining whether differential capacity peaks of the differential capacity curves and the corresponding preset cycle numbers satisfy a first linear relationship, when dissatisfy the first linear relationship, step S370 is executed; or when the differential capacity peaks of the differential capacity curves and the corresponding preset cycle numbers satisfy the first linear relationship, step S380 is executed.

At step of S370, determining that the battery to be tested is abnormal.

At step of S380, determining whether the capacity fade values and the corresponding preset cycle numbers satisfy a second linear relationship, when the capacity fade values and the corresponding preset cycle numbers satisfy the second linear relationship, step S390 is executed; or when the capacity fade values and the corresponding preset cycle numbers dissatisfy the second linear relationship, the process returns to continue to execute step S310.

At step of S390, determining a cycle number corresponding to a capacity fade threshold of the battery to be tested based on the second linear relationship, determining the cycle number corresponding to the capacity fade threshold of the battery to be tested as a life of the battery to be tested.

Optionally, the determining capacity fade values of the battery to be tested under different preset cycle numbers includes:
At step of e1, obtaining current capacities of the battery to be tested under the different preset cycle numbers.

A current capacity of the battery to be tested after the discharge process under the condition of reaching the preset cycle number is obtained. Exemplarily, when the cycle number is 200, the current capacities of the battery to be tested after the discharge process under the condition of cycle for 200 th, 150 th and 100 th can be obtained.

At step of e2, determining the capacity fade value corresponding to the different preset cycle numbers based on a difference between the current capacities of different preset cycle numbers and the standard capacity.

The current capacity corresponding to each preset cycle number is subtracted from the standard capacity to obtain the capacity fade value corresponding to each preset cycle number. For example, the capacity fade value of the battery to be tested after 200 cycle numbers can be determined by subtracting the current capacity of the battery to be tested after 200 cycle numbers from the standard capacity.

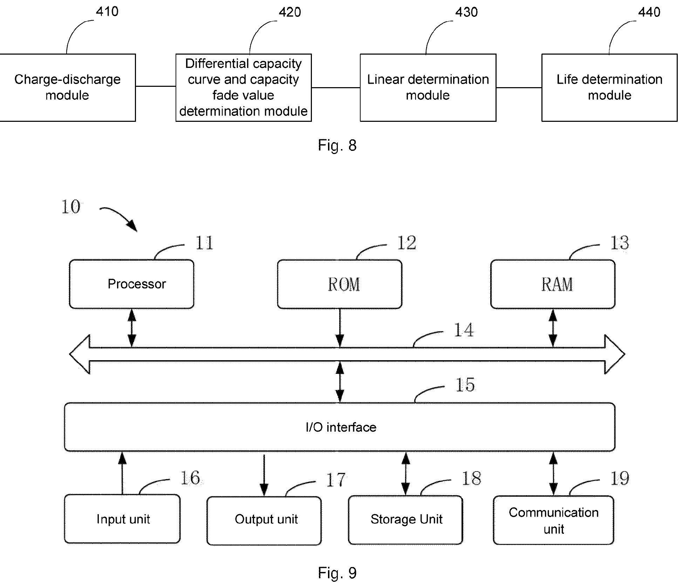

Fig. 8 is a schematic structural diagram of an apparatus for determining life of battery provided according to an embodiment of the present application. As shown in Fig. 8, the apparatus for determining life of battery includes a charge-discharge module 410, a differential capacity curve and capacity fade value determination module 420, a linear determination module 430, and a life determination module 440. The charge-discharge module 410 is configured to perform a charge-discharge cycle on a battery to be tested; the differential capacity curve and capacity fade value determination module 420 is configured to determine differential capacity curves and capacity fade values of the battery to be tested under different preset cycle numbers; the linear determination module 430 is configured to determine whether differential capacity peaks of the differential capacity curves and the corresponding preset cycle numbers satisfy a first linear relationship, and whether the capacity fade values and the corresponding preset cycle numbers satisfy a second linear relationship; and the life determination module 440 is configured to determine, when the differential capacity peaks and the corresponding preset cycle numbers satisfy the first linear relationship, and the capacity fade values and the corresponding preset cycle numbers satisfy the second linear relationship, a cycle number corresponding to a capacity fade threshold of the battery to be tested based on the second linear relationship, determining the cycle number corresponding to the capacity fade threshold of the battery to be tested as a life of the battery to be tested.

Optionally, the differential capacity curve and capacity fade value determination module 420 is configured to acquire discharge data of the battery to be tested under the different preset cycle numbers at intervals of a preset number forwards from a current cycle number obtained when the charge-discharge cycle is completed, where the discharge data includes a capacity and a discharge voltage of the battery to be tested; and determine the differential capacity curves and the capacity fade values of the battery to be tested under the different preset cycle numbers based on the discharge data.

Optionally, the apparatus for determining life of battery further includes an abnormality determination module configured to determine that the battery to be tested is abnormal when the differential capacity peaks and the corresponding preset cycle numbers dissatisfy the first linear relationship.

Optionally, the apparatus for determining life of battery further includes a standard capacity determination module configured to: obtain initial capacities of the battery to be tested during at least two initial cycles; and use an average value of the at least two initial capacities as a standard capacity of the battery to be tested.

The apparatus for determining life of battery provided by this embodiment of the present application can execute the method for determining life of battery provided by any embodiment of the present application, and has corresponding functional modules for executing the method, and effects.

FIG. 9 shows a schematic structural diagram of an electronic device that may be configured to implement the embodiment of the present application. The electronic device 10 may be various forms of digital computers, such as laptop computers, desktop computers, workstations, personal digital assistants, servers, blade servers, mainframe computers, and other suitable computers. The electronic device 10 may further represent various forms of mobile apparatuses, such as a personal digital assistant, a cellular phone, a smartphone, a wearable device (such as a helmet, a pair of glasses, and a watch), and other similar computing apparatuses. The components shown herein, their connections and relationships, and their functions are by way of example only and are not intended to limit the implementation of the present application described and/or claimed herein.

As shown in Fig. 9, the electronic device 10 includes at least one processor 11, and a memory communicatively connected to the at least one processor 11, such as a read-only memory (Read-Only Memory, ROM) 12 or a random access memory (Random Access Memory, RAM) 13, where the memory stores a computer program executable by the at least one processor 11, and the processor 11 may execute various appropriate actions and processes based on a computer program stored in the ROM 12 or a computer program loaded from a storage unit 18 into the RAM 13. Various programs and data required for operation of the electronic device 10 may also be stored in the RAM 13. The processor 11, the ROM 12, and the RAM 13 are connected to one another through a bus 14. An input/output (Input/Output, I/O) interface 15 is also connected to the bus 14.

Various components in the electronic device 10 are connected to the I/O interface 15, including: an input unit 16, such as a keyboard and a mouse; an output unit 17, such as various types of displays and loudspeakers; a memory cell 18, such as a magnetic disk and a compact disc; and a communication unit 19, such as a network card, a modem, and a wireless communication transceiver. The communication unit 19 allows the electronic device 10 to exchange information/data with other devices through a computer network such as the Internet and/or various telecommunication networks.

The processor 11 may be various general-purpose and/or specialized processing components with processing and computing capabilities. Some examples of the processor 11 include but are not limited to a central processing unit (Central Processing Unit, CPU), a graphic processing unit (Graphic Processing Unit, GPU), various specialized artificial intelligence (Artificial Intelligence, AI) computing chips, various processors that run machine learning model algorithms, a digital signal processing (Digital Signal Processing, DSP) unit, and any appropriate processors, controllers, microcontrollers, etc. The processor 11 executes a plurality of methods and processes described above, such as the method for determining life of battery.

In some embodiments, the method for determining life of battery may be implemented as a computer program, which is tangibly contained in a computer-readable storage medium, such as the storage unit 18. In some embodiments, a part or all of the computer program may be loaded and/or installed onto the electronic device 10 through the ROM 12 and/or the communication unit 19. When the computer program is loaded to the RAM 13 and executed by the processor 11, at least one steps of the method for determining life of battery described above may be executed. Alternatively, in other embodiments, the processor 11 may be configured in any other suitable manner (for example, by means of firmware) to execute the method for determining the life of a battery.

The embodiments of the system and technology described herein above may be implemented in a digital electronic circuit system, an integrated circuit system, a field programmable gate array (Field Programmable Gate Array, FPGA), an application-specific integrated circuit (Application Specific Integrated Circuit, ASIC), an application-specific standard product (Application Specific Standard Product, ASSP), a system on chip (System on Chip, SOC), a complex programmable logical device (Complex Programmable Logic Device, CPLD), computer hardware, firmware, software, and/or a combination thereof. These embodiments may be implemented in at least one computer programs, where the at least one computer programs may be executed and/or interpreted on a programmable system including at least one programmable processor. The programmable processor may be a dedicated or general-purpose programmable processor that can receive data and instructions from a storage system, at least one input apparatus, and at least one output apparatus, and transmit the data and the instructions to the storage system, the at least one input apparatus, and the at least one output apparatus.

The computer program for implementing the method in the present application may be written in at least one programming languages. These computer programs may be provided to a processor of a general purpose computer, a special purpose computer, or another programmable data processing apparatus, such that the computer programs, when executed by the processor, implement the functions/operations specified in a flowchart and/or a block diagram. The computer program may be completely or partially executed on a machine, partially executed on the machine as an independent software package and partially executed on a remote machine or completely executed on the remote machine or a server.

In the context of the present application, the computer-readable storage medium may be a tangible medium, which may contain or store a computer program for use by an instruction execution system, apparatus or device, or for use in combination with the instruction execution system, apparatus or device. The computer-readable storage medium may include but is not limited to an electronic, magnetic, optical, electromagnetic, infrared or semiconductor system, apparatus or device, or any suitable combination of the above. Alternatively, the computer-readable storage medium may be a machine-readable signal medium. The machine-readable storage medium includes an electrical connection based on at least one lines, a portable computer disk, a hard disk drive, an Random Access Memory (RAM), an Read-Only Memory (ROM), an erasable programmable read-only memory (Erasable Programmable Read-Only Memory, EPROM) or a flash memory, fiber optic, a portable compact disc read-only memory (Compact Disc Read-Only Memory, CD-ROM), an optical storage device, a magnetic storage device, or any suitable combination of the above.

In order to provide an interaction with a user, the system and technology described herein may be implemented on the electronic device 10, where the electronic device 10 includes: a display device (e.g., a cathode ray tube (Cathode Ray Tube, CRT) or a liquid crystal display (Liquid Crystal Display, LCD) monitor) configured to display information to the user; and a keyboard and a pointing device (e.g., a mouse or a trackball), through which the user can provide an input to the electronic device 10. Other kinds of devices may also be configured to provide an interaction with the user. For example, a feedback provided to the user may be any form of sensory feedback (e.g., visual feedback, auditory feedback, or tactile feedback), and an input from the user may be received in any form (including an acoustic input, a voice input or a tactile input).

The system and technology described herein may be implemented in a computing system (for example, as a data server) including a backend component, a computing system (for example, an application server) including a middleware component, or a computing system (for example, a user computer with a graphical user interface or a web browser through which the user can interact with the embodiments of the system and technology described herein) including a frontend component, or a computing system including any combination of the backend component, the middleware component, or the frontend component. The components of the system may be connected to each other through digital data communication (for example, a communication network) in any form or medium. Examples of the communication network include a local area network (Local Area Network, LAN), a wide area network (Wide Area Network, WAN), a blockchain network, and the Internet.

The computing system may include a client and a server. The client and the server are generally far away from each other and usually interact through the communication network. A relationship between the client and the server is generated by running computer programs having a client-server relationship on corresponding computers. The server may be a cloud server, also known as a cloud computing server or a cloud host, which is a host product in the cloud computing service system that solves the problems of high management difficulty and weak business scalability in services of traditional physical hosts and virtual private servers (Virtual Private Server, VPS).

The steps described in the present application may be executed concurrently, sequentially or in a different order, so long as the desired results of the technical solutions of the present application can be achieved, and there is no limitation herein.

## Claims

1. A method for determining life of battery, comprising a first linear determination process and a life determination process,
wherein the first linear determination process comprising:
performing (S110) a charge-discharge cycle on a battery to be tested for a first cycle number;
determining (S120) differential capacity curves and capacity fade values of the battery to be tested under different preset cycle numbers;
executing the life determination process when the differential capacity peaks of the differential capacity curves and the corresponding preset cycle numbers satisfy a first linear relationship, and the capacity fade values and the corresponding preset cycle numbers satisfy a second linear relationship;
the life determination process comprising: determining (S150) a cycle number corresponding to a capacity fade threshold of the battery to be tested based on the second linear relationship, determining the cycle number corresponding to the capacity fade threshold of the battery to be tested as a life of the battery to be tested.

2. The method as claimed in claim 1, wherein the method further comprising:
when the differential capacity peaks of the differential capacity curves and the corresponding preset cycle numbers satisfy a first linear relationship, and the capacity fade values and the corresponding preset cycle numbers dissatisfy a second linear relationship, continuing to perform a charge-discharge cycle on the battery to be tested for a second cycle number, to execute a second linear determination process.

3. The method as claimed in claim 1, wherein the differential capacity curve comprises at least one characteristic peak, the at least one characteristic peak represents that a material of the battery to be tested undergoes a phase change, a differential capacity peak of the differential capacity curve is a peak value corresponding to a first characteristic peak, the first characteristic peak is a characteristic peak corresponding to a minimum discharge voltage in the at least one characteristic peak.

4. The method as claimed in claim 1, wherein determining whether the differential capacity peaks and the corresponding preset cycle numbers satisfy the first linear relationship comprises:
performing linear fitting on each differential capacity peak and a corresponding preset cycle number based on the first linear relationship to obtain a first function;
determining that the each differential capacity peak and the corresponding preset cycle number satisfy the first linear relationship when a first fitting variance of the first function is within a first preset range.

5. The method as claimed in claim 4, wherein the first linear relationship is y₁ = a₁x + b₁, where y₁ is the peak differential capacity, x is the first cycle number or the second cycle number, a₁ is a first proportionality coefficient, and b₁ is a first constant coefficient.

6. The method as claimed in claim 1, wherein determining whether the capacity fade values and the corresponding preset cycle numbers satisfy the second linear relationship comprises:
performing linear fitting on each capacity fade value and a corresponding preset cycle number based on the second linear relationship to obtain a second function;
determining that the each capacity fade value and the corresponding preset cycle number satisfy the second linear relationship when a second fitting variance of the second function is within a first preset range.

7. The method as claimed in claim 6, wherein the second linear relationship is lny₂ = a₂lnx + b₂, where y₂ is the capacity fade value, x is the first cycle number or the second cycle number, a₂ is a second proportionality coefficient, and b₂ is a second constant coefficient.

8. An apparatus for determining life of battery, comprising:
a charge-discharge module (410), configured to perform a charge-discharge cycle on a battery to be tested;
a differential capacity curve and capacity fade value determination module (420), configured to determine differential capacity curves and capacity fade values of the battery to be tested under different preset cycle numbers;
a linear determination module (430), configured to determine whether differential capacity peaks of the differential capacity curves and corresponding preset cycle numbers satisfy a first linear relationship, and whether the capacity fade values and corresponding preset cycle numbers satisfy a second linear relationship; and
a life determination module (440), configured to determine, when the differential capacity peaks and the corresponding preset cycle numbers satisfy the first linear relationship, and the capacity fade values and the corresponding preset cycle numbers satisfy the second linear relationship, a cycle number corresponding to a capacity fade threshold of the battery to be tested based on the second linear relationship, determining the cycle number corresponding to the capacity fade threshold of the battery to be tested as a life of the battery to be tested.

9. A computer-readable storage medium, wherein the computer-readable storage medium stores a computer instruction, and the computer instruction is used to implement the method for determining the life of a battery according to any one of claims 1 to 7 when executed by a processor.

10. The apparatus for determining life of battery claimed in claim 8, wherein the apparatus, configured to, when the differential capacity peaks of the differential capacity curves and the corresponding preset cycle numbers satisfy a first linear relationship, and the capacity fade values and the corresponding preset cycle numbers dissatisfy a second linear relationship, continue to perform a charge-discharge cycle on the battery to be tested for a second cycle number, to execute a second linear determination process.

11. The apparatus for determining life of battery claimed in claim 8, wherein the differential capacity curve comprises at least one characteristic peak, the at least one characteristic peak represents that a material of the battery to be tested undergoes a phase change, a differential capacity peak of the differential capacity curve is a peak value corresponding to a first characteristic peak, the first characteristic peak is a characteristic peak corresponding to a minimum discharge voltage in the at least one characteristic peak.

12. The apparatus for determining life of battery claimed in claim 8, wherein the apparatus, configured to perform linear fitting on each differential capacity peak and a corresponding preset cycle number based on the first linear relationship to obtain a first function; determine that the each differential capacity peak and the corresponding preset cycle number satisfy the first linear relationship when a first fitting variance of the first function is within a first preset range.

13. The apparatus for determining life of battery claimed in claim 12, wherein the first linear relationship is y₁ = a₁x + b₁, where y₁ is the peak differential capacity, x is the first cycle number or the second cycle number, a₁ is a first proportionality coefficient, and b₁ is a first constant coefficient.

14. The apparatus for determining life of battery claimed in claim 8, wherein the apparatus, configured to perform linear fitting on each capacity fade value and a corresponding preset cycle number based on the second linear relationship to obtain a second function; determine that the each capacity fade value and the corresponding preset cycle number satisfy the second linear relationship when a second fitting variance of the second function is within a first preset range.

15. The apparatus for determining life of battery claimed in claim 14, wherein the second linear relationship is lny₂ = a₂lnx + b₂, where y₂ is the capacity fade value, x is the first cycle number or the second cycle number, a₂ is a second proportionality coefficient, and b₂ is a second constant coefficient.

## Patentansprüche

1. Verfahren zur Ermittlung der Lebensdauer einer Batterie, das einen ersten linearen Ermittlungsprozess und einen Lebensdauerermittlungsprozess umfasst,
wobei der erste lineare Ermittlungsprozess umfasst:
Durchführen (S110) eines Lade-Entlade-Zyklus an einer zu testenden Batterie für eine erste Zykluszahl;
Ermitteln (S120) von Differenzkapazitätskurven und Kapazitätsschwundwerten der zu testenden Batterie unter verschiedenen voreingestellten Zykluszahlen;
Ausführen des Lebensdauerermittlungsprozesses, wenn die Differenzkapazitätsspitzen der Differenzkapazitätskurven und die entsprechenden voreingestellten Zykluszahlen eine erste lineare Beziehung erfüllen und die Kapazitätsschwundwerte und die entsprechenden voreingestellten Zykluszahlen eine zweite lineare Beziehung erfüllen;
wobei der Lebensdauerermittlungsprozess Folgendes umfasst: Ermitteln (S150) einer Zykluszahl, die einem Kapazitätsschwundschwellenwert der zu testenden Batterie entspricht, auf Grundlage der zweiten linearen Beziehung, Ermitteln der Zykluszahl, die dem Kapazitätsschwundschwellenwert der zu testenden Batterie entspricht, als eine Lebensdauer der zu testenden Batterie.

2. Verfahren nach Anspruch 1, wobei das Verfahren ferner umfasst:
wenn die Differenzkapazitätsspitzen der Differenzkapazitätskurven und die entsprechenden voreingestellten Zykluszahlen eine erste lineare Beziehung erfüllen und die Kapazitätsschwundwerte und die entsprechenden voreingestellten Zykluszahlen eine zweite lineare Beziehung nicht erfüllen, Fortsetzen mit der Durchführung eines Lade-Entlade-Zyklus an der zu testenden Batterie für eine zweite Zykluszahl, um einen zweiten linearen Ermittlungsprozess auszuführen.

3. Verfahren nach Anspruch 1, wobei die Differenzkapazitätskurve zumindest eine charakteristische Spitze umfasst, die zumindest eine charakteristische Spitze repräsentiert, dass ein Material der zu testenden Batterie eine Phasenänderung erfährt, eine Differenzkapazitätsspitze der Differenzkapazitätskurve ein Spitzenwert ist, der einer ersten charakteristischen Spitze entspricht, die erste charakteristische Spitze eine charakteristische Spitze ist, die einer minimalen Entladespannung in der zumindest einen charakteristischen Spitze entspricht.

4. Verfahren nach Anspruch 1, wobei das Ermitteln, ob die Differenzkapazitätsspitzen und die entsprechenden voreingestellten Zykluszahlen die erste lineare Beziehung erfüllen, Folgendes umfasst:
Durchführen einer linearen Anpassung an jeder Differenzkapazitätsspitze und einer entsprechenden voreingestellten Zykluszahl auf Grundlage der ersten linearen Beziehung, um eine erste Funktion zu erhalten;
Ermitteln, dass die jeweilige Differenzkapazitätsspitze und die entsprechende voreingestellte Zykluszahl die erste lineare Beziehung erfüllen, wenn eine erste Anpassungsvarianz der ersten Funktion innerhalb eines ersten voreingestellten Bereichs liegt.

5. Verfahren nach Anspruch 4, wobei die erste lineare Beziehung y₁ = a₁x + b₁ ist, wobei y₁ die Spitzendifferenzkapazität ist, x die erste Zykluszahl oder die zweite Zykluszahl ist, a₁ ein erster Proportionalitätskoeffizient ist und b₁ ein erster konstanter Koeffizient ist.

6. Verfahren nach Anspruch 1, wobei das Ermitteln, ob die Kapazitätsschwundwerte und die entsprechenden voreingestellten Zykluszahlen die zweite lineare Beziehung erfüllen, Folgendes umfasst:
Durchführen einer linearen Anpassung an jedem Kapazitätsschwundwert und einer entsprechenden voreingestellten Zykluszahl auf Grundlage der zweiten linearen Beziehung, um eine zweite Funktion zu erhalten;
Ermitteln, dass der jeweilige Kapazitätsschwundwert und die entsprechende voreingestellte Zykluszahl die zweite lineare Beziehung erfüllen, wenn eine zweite Anpassungsvarianz der zweiten Funktion innerhalb eines ersten voreingestellten Bereichs liegt.

7. Verfahren nach Anspruch 6, wobei die zweite lineare Beziehung Iny₂ = a₂Inx + b₂ ist, wobei y₂ der Kapazitätsschwundwert ist, x die erste Zykluszahl oder die zweite Zykluszahl ist, a₂ ein zweiter Proportionalitätskoeffizient ist und b₂ ein zweiter konstanter Koeffizient ist.

8. Gerät zur Ermittlung der Lebensdauer einer Batterie, das Folgendes umfasst:
ein Lade-Entlade-Modul (410),
das konfiguriert ist, um einen Lade-Entlade-Zyklus an einer zu testenden Batterie durchzuführen;
ein Differenzkapazitätskurven- und Kapazitätsschwundwertermittlungsmodul (420), das dazu konfiguriert ist, Differenzkapazitätskurven und Kapazitätsschwundwerte der zu testenden Batterie unter verschiedenen voreingestellten Zykluszahlen zu ermitteln;
ein lineares Ermittlungsmodul (430), das konfiguriert ist, um zu ermitteln, ob Differenzkapazitätsspitzen der Differenzkapazitätskurven und entsprechende voreingestellte Zykluszahlen eine erste lineare Beziehung erfüllen und ob die Kapazitätsschwundwerte und entsprechende voreingestellte Zykluszahlen eine zweite lineare Beziehung erfüllen; und
ein Lebensdauerermittlungsmodul (440), das konfiguriert ist, wenn die Differenzkapazitätsspitzen und die entsprechenden voreingestellten Zykluszahlen die erste lineare Beziehung erfüllen und die Kapazitätsschwundwerte und die entsprechenden voreingestellten Zykluszahlen die zweite lineare Beziehung erfüllen, um eine Zykluszahl, die einem Kapazitätsschwundschwellenwert der zu testenden Batterie entspricht, auf Grundlage der zweiten linearen Beziehung zu ermitteln, indem die Zykluszahl, die dem Kapazitätsschwundschwellenwert der zu testenden Batterie entspricht, als eine Lebensdauer der zu testenden Batterie ermittelt wird.

9. Computerlesbares Speichermedium, wobei das computerlesbare Speichermedium einen Computerbefehl speichert und der Computerbefehl verwendet wird, um das Verfahren zur Ermittlung der Lebensdauer einer Batterie nach einem der Ansprüche 1 bis 7 zu implementieren, wenn es von einem Prozessor ausgeführt wird.

10. Gerät zur Ermittlung der Lebensdauer einer Batterie nach Anspruch 8, wobei das Gerät konfiguriert ist, wenn die Differenzkapazitätsspitzen der Differenzkapazitätskurven und die entsprechenden voreingestellten Zykluszahlen eine erste lineare Beziehung erfüllen und die Kapazitätsschwundwerte und die entsprechenden voreingestellten Zykluszahlen eine zweite lineare Beziehung nicht erfüllen, um mit der Durchführung eines Lade-Entlade-Zyklus an der zu testenden Batterie für eine zweite Zykluszahl fortzusetzen, um einen zweiten linearen Ermittlungsprozess auszuführen.

11. Gerät zur Ermittlung der Lebensdauer einer Batterie nach Anspruch 8, wobei die Differenzkapazitätskurve zumindest eine charakteristische Spitze umfasst, die zumindest eine charakteristische Spitze repräsentiert, dass ein Material der zu testenden Batterie eine Phasenänderung erfährt, eine Differenzkapazitätsspitze der Differenzkapazitätskurve ein Spitzenwert ist, der einer ersten charakteristischen Spitze entspricht, die erste charakteristische Spitze eine charakteristische Spitze ist, die einer minimalen Entladespannung in der zumindest einen charakteristischen Spitze entspricht.

12. Gerät zur Ermittlung der Lebensdauer einer Batterie nach Anspruch 8, wobei das Gerät konfiguriert ist, eine lineare Anpassung an jeder Differenzkapazitätsspitze und einer entsprechenden voreingestellten Zykluszahl auf Grundlage der ersten linearen Beziehung durchzuführen, um eine erste Funktion zu erhalten, um zu ermitteln, dass die jeweilige Differenzkapazitätsspitze und die entsprechende voreingestellte Zykluszahl die erste lineare Beziehung erfüllen, wenn eine erste Anpassungsvarianz der ersten Funktion innerhalb eines ersten voreingestellten Bereichs liegt.

13. Gerät zur Ermittlung der Lebensdauer einer Batterie nach Anspruch 12, wobei die erste lineare Beziehung y₁ = a₁x + b₁ ist, wobei y₁ die Spitzendifferenzkapazität ist, x die erste Zykluszahl oder die zweite Zykluszahl ist, a₁ ein erster Proportionalitätskoeffizient ist und b₁ ein erster konstanter Koeffizient ist.

14. Gerät zur Ermittlung der Lebensdauer einer Batterie nach Anspruch 8, wobei das Gerät konfiguriert ist, eine lineare Anpassung an jedem Kapazitätsschwundwert und einer entsprechenden voreingestellten Zykluszahl auf Grundlage der zweiten linearen Beziehung durchzuführen, um eine zweite Funktion zu erhalten, um zu ermitteln, dass der jeweilige Kapazitätsschwundwert und die entsprechende voreingestellte Zykluszahl die zweite lineare Beziehung erfüllen, wenn eine zweite Anpassungsvarianz der zweiten Funktion innerhalb eines ersten voreingestellten Bereichs liegt.

15. Gerät zur Ermittlung der Lebensdauer einer Batterie nach Anspruch 14, wobei die zweite lineare Beziehung Iny₂ = a₂Inx + b₂ ist, wobei y₂ der Kapazitätsschwundwert ist, x die erste Zykluszahl oder die zweite Zykluszahl ist, a₂ ein zweiter Proportionalitätskoeffizient ist und b₂ ein zweiter konstanter Koeffizient ist.

## Revendications

1. Procédé de détermination de la durée de vie d'une batterie, comprenant un premier processus de détermination linéaire et un processus de détermination de la durée de vie,
dans lequel le premier processus de détermination linéaire comprend :
exécuter (S110) un cycle de charge-décharge sur une batterie à tester pour un premier nombre de cycles ;
déterminer (S120) des courbes de capacité différentielle et des valeurs de perte de capacité de la batterie à tester pour différents nombres de cycles prédéfinis ;
exécuter le processus de détermination de la durée de vie lorsque les pics de capacité différentielle des courbes de capacité différentielle et les nombres de cycles prédéfinis correspondants satisfont à une première relation linéaire, et les valeurs de perte de capacité et les nombres de cycles prédéfinis correspondants satisfont à une deuxième relation linéaire ;
le processus de détermination de la durée de vie comprenant : déterminer (S150) un nombre de cycles correspondant à un seuil de perte de capacité de la batterie à tester sur la base de la deuxième relation linéaire, déterminer le nombre de cycles correspondant au seuil de perte de capacité de la batterie à tester comme durée de vie de la batterie à tester.

2. Procédé selon la revendication 1, dans lequel le procédé comprend en outre :
lorsque les pics de capacité différentielle des courbes de capacité différentielle et les nombres de cycles prédéfinis correspondants satisfont à une première relation linéaire, et que les valeurs de perte de capacité et les nombres de cycles prédéfinis correspondants ne satisfont pas à une deuxième relation linéaire, poursuivre l'exécution d'un cycle de charge-décharge sur la batterie à tester pour un deuxième nombre de cycles, afin d'exécuter un deuxième processus de détermination linéaire.

3. Procédé selon la revendication 1, dans lequel la courbe de capacité différentielle comprend au moins un pic caractéristique, ledit au moins un pic caractéristique indiquant qu'un matériau de la batterie à tester subit un changement de phase, un pic de capacité différentielle de la courbe de capacité différentielle est une valeur de pic correspondant à un premier pic caractéristique, le premier pic caractéristique est un pic caractéristique correspondant à une tension de décharge minimale dans ledit au moins un pic caractéristique.

4. Procédé selon la revendication 1, dans lequel la détermination visant à établir si les pics de capacité différentielle et les nombres de cycles prédéfinis correspondants satisfont à la première relation linéaire comprend :
effectuer un ajustement linéaire sur chaque pic de capacité différentielle et un nombre de cycles prédéfini correspondant sur la base de la première relation linéaire afin d'obtenir une première fonction ;
déterminer que chaque pic de capacité différentielle et le nombre de cycles prédéfini correspondant satisfont à la première relation linéaire lorsqu'une première variance d'ajustement de la première fonction se situe dans une première plage prédéfinie.

5. Procédé selon la revendication 4, dans lequel la première relation linéaire est y₁ = a₁x + b₁, où y₁ est la capacité différentielle de pic, x est le premier nombre de cycles ou le deuxième nombre de cycles, a₁ est un premier coefficient de proportionnalité, et b₁ est un premier coefficient constant.

6. Procédé selon la revendication 1, dans lequel la détermination visant à établir si les valeurs de perte de capacité et les nombres de cycles prédéfinis correspondants satisfont à la deuxième relation linéaire comprend :
effectuer un ajustement linéaire sur chaque valeur de perte de capacité et un nombre de cycles prédéfini correspondant sur la base de la deuxième relation linéaire afin d'obtenir une deuxième fonction
déterminer que chaque valeur de perte de capacité et le nombre de cycles prédéfini correspondant satisfont à la deuxième relation linéaire lorsqu'une deuxième variance d'ajustement de la deuxième fonction se situe dans une première plage prédéfinie.

7. Procédé selon la revendication 6, dans lequel la deuxième relation linéaire est Iny₂ = a₂Inx + b₂, où y₂ est la valeur de perte de capacité, x est le premier nombre de cycles ou le deuxième nombre de cycles, a₂ est un deuxième coefficient de proportionnalité, et b₂ est un deuxième coefficient constant.

8. Appareil de détermination de la durée de vie d'une batterie, comprenant :
un module de charge-décharge (410),
conçu pour exécuter un cycle de charge-décharge sur une batterie à tester ;
un module de détermination de courbes de capacité différentielle et de valeurs de perte de capacité (420), conçu pour déterminer des courbes de capacité différentielle et des valeurs de perte de capacité de la batterie à tester pour différents nombres de cycles prédéfinis ;
un module de détermination linéaire (430), conçu pour déterminer si des pics de capacité différentielle des courbes de capacité différentielle et des nombres de cycles prédéfinis correspondants satisfont à une première relation linéaire, et si les valeurs de perte de capacité et les nombres de cycles prédéfinis correspondants satisfont à une deuxième relation linéaire ; et
un module de détermination de la durée de vie (440), conçu pour déterminer, lorsque les pics de capacité différentielle et les nombres de cycles prédéfinis correspondants satisfont à la première relation linéaire, et que les valeurs de perte de capacité et les nombres de cycles prédéfinis correspondants satisfont à la deuxième relation linéaire, un nombre de cycles correspondant à un seuil de perte de capacité de la batterie à tester sur la base de la deuxième relation linéaire, en déterminant le nombre de cycles correspondant au seuil de perte de capacité de la batterie à tester comme durée de vie de la batterie à tester.

9. Support de stockage lisible par ordinateur, dans lequel le support de stockage lisible par ordinateur stocke une instruction informatique, et l'instruction informatique est utilisée pour mettre en œuvre le procédé de détermination de la durée de vie d'une batterie selon l'une quelconque des revendications 1 à 7 lorsqu'elle est exécutée par un processeur.

10. Appareil de détermination de la durée de vie d'une batterie selon la revendication 8, dans lequel l'appareil est conçu pour, lorsque les pics de capacité différentielle des courbes de capacité différentielle et les nombres de cycles prédéfinis correspondants satisfont à une première relation linéaire, et que les valeurs de perte de capacité et les nombres de cycles prédéfinis correspondants ne satisfont pas à une deuxième relation linéaire, continuer à exécuter un cycle de charge-décharge sur la batterie à tester pour un deuxième nombre de cycles, afin d'exécuter un deuxième processus de détermination linéaire.

11. Appareil de détermination de la durée de vie d'une batterie selon la revendication 8, dans lequel la courbe de capacité différentielle comprend au moins un pic caractéristique, ledit au moins un pic caractéristique indiquant qu'un matériau de la batterie à tester subit un changement de phase, un pic de capacité différentielle de la courbe de capacité différentielle est une valeur de pic correspondant à un premier pic caractéristique, le premier pic caractéristique est un pic caractéristique correspondant à une tension de décharge minimale dans ledit au moins un pic caractéristique.

12. Appareil de détermination de la durée de vie d'une batterie selon la revendication 8, dans lequel l'appareil est conçu pour effectuer un ajustement linéaire sur chaque pic de capacité différentielle et un nombre de cycles prédéfini correspondant sur la base de la première relation linéaire afin d'obtenir une première fonction ; déterminer que chaque pic de capacité différentielle et le nombre de cycles prédéfini correspondant satisfont à la première relation linéaire lorsque une première variance d'ajustement de la première fonction se situe dans une première plage prédéfinie.

13. Appareil de détermination de la durée de vie d'une batterie selon la revendication 12, dans lequel la première relation linéaire est y₁ = a₁x + b₁, où y₁ est la capacité différentielle de pic, x est le premier nombre de cycles ou le deuxième nombre de cycles, a₁ est un premier coefficient de proportionnalité et b₁ est un premier coefficient constant.

14. Appareil de détermination de la durée de vie d'une batterie selon la revendication 8, dans lequel l'appareil est conçu pour effectuer un ajustement linéaire sur chaque valeur de perte de capacité et un nombre de cycles prédéfini correspondant sur la base de la deuxième relation linéaire afin d'obtenir une deuxième fonction ; déterminer que chaque valeur de perte de capacité et le nombre de cycles prédéfini correspondant satisfont à la deuxième relation linéaire lorsque une deuxième variance d'ajustement de la deuxième fonction se situe dans une première plage prédéfinie.

15. Appareil de détermination de la durée de vie d'une batterie selon la revendication 14, dans lequel la deuxième relation linéaire est Iny₂ = a₂Inx + b₂, où y₂ est la valeur de perte de capacité, x est le premier nombre de cycles ou le deuxième nombre de cycles, a₂ est un deuxième coefficient de proportionnalité et b₂ est un deuxième coefficient constant.
